# EUROPEAN PATENT APPLICATION

(11) **EP 3 829 277 A1**
(43) Date of publication of application: **02.06.2021**
(21) Application number: 19212304.0
(22) Date of filing: 28.11.2019
(51) Int. Cl.: H05K 7/20

(54) **CABINET COOLING SYSTEM**

(71) Applicant: Siemens Gamesa Renewable Energy A/S, 7330 Brande (DK)
(72) Inventor: Groenheden, Ebbe, 8700 Horsens (DK)
(74) Representative: Aspacher, Karl-Georg

(57) **Abstract**

A cabinet cooling system (40) is described. The cabinet cooling system (40) comprises a communicating cooling ventilation air ducting tube system. Further, the cabinet cooling system (40) includes one single central fan (45). Furthermore, the cabinet cooling system (40) comprises at least one inlet (41a, 42a) and at least one outlet (41b, 42b). The cabinet cooling system (40), furthermore, comprises an exhaust duct system (44) connected to the at least one outlet (41b, 42b). Also a wind turbine (80) is described. Additionally, a method of manufacturing a cabinet cooling system (40) is described.

## Description

The invention concerns a cabinet cooling system. Further, the invention relates to a method for manufacturing a cooling system.

Cabinet cooling systems are broadly used for tempering technical devices or rooms without any central cooling or ventilation system. For example, such a cabinet cooling system is used to control the temperature of electrical components inside a nacelle of a wind turbine.

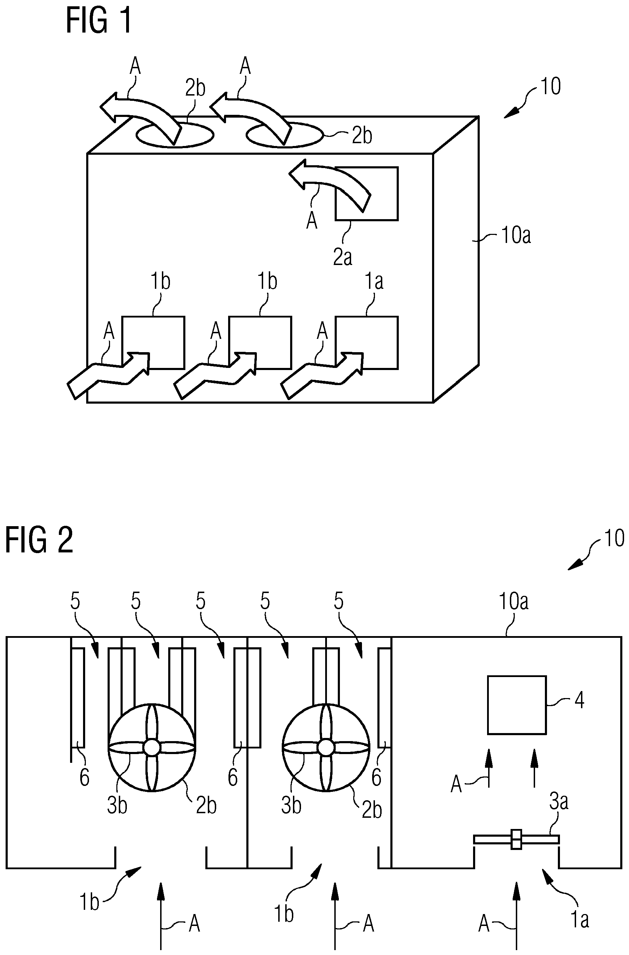

Conventionally, electrical cabinet cooling systems are locally controlled by individual fans, which suck air through an inlet thereby creating an negative pressure in the cabinet. Further, the fans may be located in an air inlet frame and blow air out of the compartment with an overpressure. A location with a fan, which blows in air is typically used to improve cooling of a component by the jet stream of the fan. Both types of use of a fan are illustrated in FIG 1.

However, there is a problem of durability and efficiency of the fans. Each fan has merely a poor efficiency of 26 to 30 % and a relatively short lifetime. Hence a failure can occur quite often. A typical cabinet with high development of heat has about six fans. Each failure of a fan stops it and two service technicians must pay an unscheduled visit to the turbine and replace the fan. Furthermore, due to the rejection of heated air in to the nacelle ambient, the turbine capability is reduced at very high ambient temperatures such as 40 °C.

Hence, there is a need for a more reliable cabinet cooling system.

This problem is solved by a cabinet cooling system according to claim 1, by a wind turbine according to claim 5 and a method of manufacturing a cabinet cooling system according to claim 6.

The cabinet cooling system according to the invention comprises a communicating cooling ventilation air ducting tube system. This means that all parts of the air ducting tube system are joined to each other. Further the cabinet cooling system includes one single central fan. Furthermore, the cabinet cooling system comprises at least one inlet and at least one outlet. The at least one inlet may comprise a nozzle for creating an inlet jet stream for directly cooling a hot component inside the cabinet. The cabinet cooling system, furthermore, comprises an exhaust duct system connected to the at least one outlet. The mentioned cabinet cooling system may be applied in a wind turbine. The advantage of the cabinet cooling system according to the invention is the much higher efficiency of the fan. Since it is only a single fan, the size of the fan is much higher and the efficiency can be increased to between 50 and 70 %. The fan creates a common negative pressure in the channel system of the ducting tubes. Furthermore, the ducts may be sized such that electrical cabinet compartments each receive the requested airflow. For compartments, which used to have an overpressure with the fan blowing directly onto a hot component, the inlet is replaced with a nozzle design, creating a jet stream for local improved cooling. The exhaust duct system is used for rejecting the hot air to outside the nacelle canopy through this exhaust duct system. This enables reduction of the local air temperature by eliminating recirculation of hot air, thereby improving turbine operation at very high ambient temperatures.

Further, in case of an application in a wind turbine, concerning service frequency, the use of a single fan reduces the number of approximately 30 unscheduled service visits to less than 4 in the turbine lifetime.

The wind turbine according to the invention comprises the cabinet cooling system according to the invention. The wind turbine according to the invention shares the advantages of the cabinet cooling system according to the invention.

According to the method of manufacturing a cabinet cooling system is provided. Further, a communicating cooling ventilation air ducting tube system through the cabinet is installed in the cabinet. Moreover the communicating cooling ventilation air ducting tube system is provided with at least one inlet and at least one outlet. Furthermore an exhaust duct system is mounted on the top of the cabinet and is connected to the at least one outlet. Moreover one single central fan is inserted in the air ducting tube system. The at least one inlet may be provided with a nozzle for creating an inlet jet stream for directly cooling a hot component into the cabinet, which is installed in the cabinet. The method of manufacturing a cabinet cooling system shares the advantages of the cabinet cooling system according to the invention. Particularly advantageous embodiments and features of the invention are given by the dependent claims, as revealed in the following description. Features of different claim categories may be combined as appropriate to give further embodiments not described herein.

According to a variation of the cabinet cooling system, the cabinet cooling system further comprises a silencer for reducing overall noise.

Preferably the central fan of the cabinet cooling system is positioned at an end portion of the duct. Hence hot air of all parts of the air duct systems can be sucked out of the cabinet.

Other objects and features of the present invention will become apparent from the following detailed descriptions considered in conjunction with the accompanying drawings. It is to be understood, however, that the drawings are designed solely for the purposes of illustration and not as a definition of the limits of the invention. They are not necessarily drawn to scale.
FIG 1 shows a schematic perspective view of a cabinet cooling system according to prior art,
FIG 2 shows a top view on the cabinet cooling system according to the prior art of FIG 1,
FIG 3 shows a side view on the cabinet cooling system according to the prior art of FIG 1 and FIG 2,
FIG 4 shows a schematic perspective depiction of a cabinet cooling system according to an embodiment of the invention,
FIG 5 shows a top view of the cabinet cooling system of FIG 4,
FIG 6 shows a side view of the cabinet cooling system of FIG 4 and FIG 5,
FIG 7 shows a flow chart depicting a method for manufacturing a cabinet cooling system according to an embodiment of the invention,
FIG 8 shows a schematic cross section of a wind turbine according to an embodiment of the invention.

In FIG 1 a schematic perspective view of a cabinet cooling system 10 according to prior art is shown. As can be taken from FIG 1, the cabinet cooling system 10 comprises a cabinet 10a, which contains all the cooling equipment. Further, the cabinet cooling system 10 also includes air inlets 1a, 1b. A first air inlet 1a, which is located on the lower right side of the cabinet 10a, is designed as a fan inlet, wherein a fan 3a (shown in FIG 2) is directly mounted in the air inlet frame thus blowing air A onto a technical component 4 (shown in FIG 2) to be cooled with overpressure. Two second air inlets 1b are shown in the lower mid side and the lower left side of the cabinet 10a. Further, a first air outlet 2a, which corresponds to the first air inlet 1a, is located at the upper right side of the cabinet 10a. Furthermore, two second air outlets 2b are mounted on the upper mid side and the upper left side of the cabinet 10a. The second air outlets 2b are constructed as fan outlets, which means that there are fans 3B (shown in FIG 2) in the outlet frame and thus blowing air A out of the cabinet 10a.

In FIG 2 a top view of the cabinet cooling system 10 according to the prior art of FIG 1 is shown in detail. As you can see from the top view, the cabinet cooling system 10 comprises a first fan 3a, which is installed in the first air inlet 1a. The first air inlet 1a is positioned at the right side of the cabinet 10a. Further, the cabinet cooling system 10 also comprises some additional fans 3b at the air outlets 2b, which are shown on the left side and the mid side of the cabinet 10a. The additional fans 3b are mounted on the top side of the cabinet 10a. As you can see from FIG 2, the first air inlet 1a blows air A from the environment of the cabinet 10a into the interior of the cabinet 10a and directly cools the technical unit 4. The additional fans 3b suck air through the second air inlets 1b such that compartments 5 containing some electronic systems 6 are also cooled. After flowing through the compartments 5, the cooling air A is sucked out of the cabinet 10a by the fans 3b on the top of the cabinet 10a. As can be seen from FIG 2, each of the fans 3a, 3b is assigned to a separated portion of the cabinet 10a.

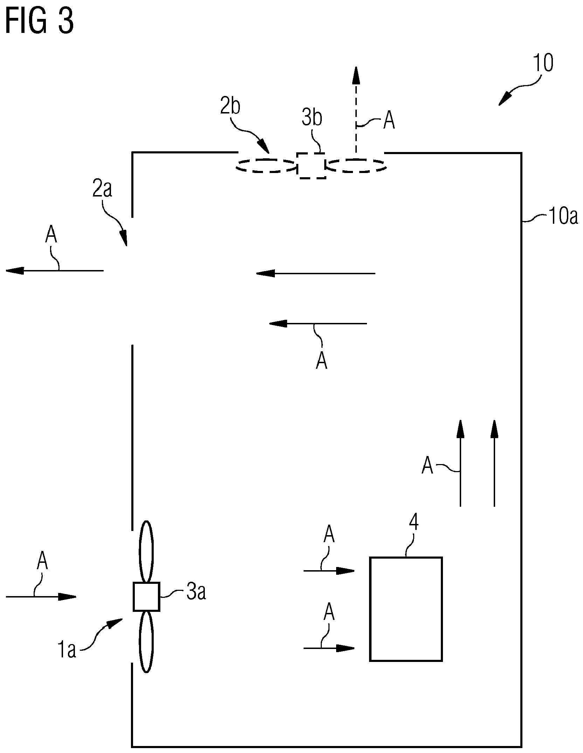

In FIG 3 a side view of the cabinet cooling system 10 according to prior art of FIG 1 and FIG 2 is shown in detail. As can be taken from FIG 3, the air A sucked through the first air inlet 1a, is pressed to the technical unit 4 and further the heated air is transported upwards upside and is exhausted through the first air outlet 2a on the upper side of the cabinet 10a. The additional air fan 3b, illustrated by dashed lines, is completely separated from the air stream, which cools the technical unit 4 and is merely illustrated in FIG 3 for a better orientation.

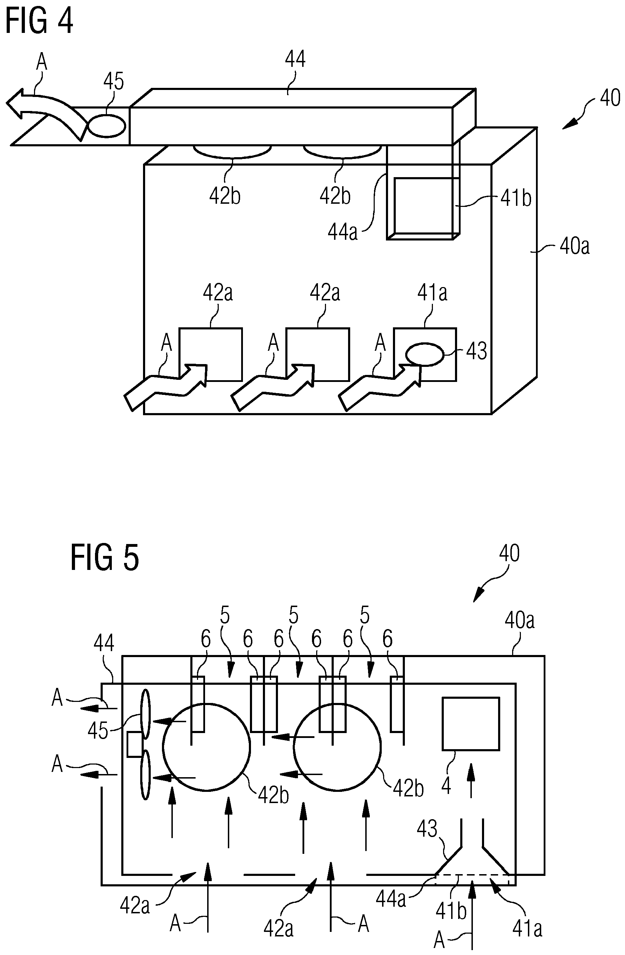

In FIG 4 a schematic perspective view of a cabinet cooling system 40 according to an embodiment of the invention is shown. The cabinet cooling system 40 comprises a cabinet 40a, which contains all the cooling equipment and the technical device to be cooled. Further, the cabinet cooling system 40 includes a central shared cooling fan 45, which is positioned on the upper left side in FIG 4. The cabinet cooling system 40 further comprises a first inlet 41a, which is used for a component 4, which has to be cooled by an overpressure for directly cooling the component 4. Therefore, the first inlet 41a has a nozzle 43, which creates a jet stream for local improved cooling. Further, the cabinet cooling system 40 comprises two second air inlets 42a at the lower left and mid side of the cabinet cooling system 40 without a nozzle. Furthermore, the cabinet cooling system 40 comprises a first air outlet 41b at the upper right side of the cabinet. The cabinet cooling system 40, furthermore, includes two second air outlets 42b at the top side of the cabinet 40a. Further, the cabinet cooling system 40 includes an exhaust duct system 44, which is mounted in front of and above the three air outlets 41b, 42b. The exhaust duct system comprises an outlet air duct 44a, which leads the air A from the first outlet 41b upside to the top side of the cabinet cooling system 40. At the left side of the exhaust duct system 44 the central fan 45 is mounted, which sucks the air A out of the cabinet 40a and rejects the hot air to outside. By rejecting the hot air to the ambient rather than a shared nacelle air, the overall cooling of all the cabinets is improved.

In FIG 5 a top view of the cabinet cooling system 40 of FIG 4 is shown. As can be taken from FIG 5, the cabinet 40a of the cabinet cooling system 40 comprises one single common interior space, through which cooling air A coming from the air inlets 41a, 42a flows. The first air inlet 41a is provided with a nozzle 43, which increases pressure of the sucked air A for cooling the hot technical unit 4. After cooling the technical unit 4, the air A flows upwards and leaves the cabinet 10a through a first outlet 41b and further flows through an outlet air duct 44a, which is part of the exhaust duct system 44 mentioned above, onto the top of the cabinet 10a. In the exhaust duct system 44 the heated air is pressed out by the central fan 45. The additional air inlet 42a also takes in some cooling air A, which streams through the compartments 5 on the mid side and the left side of the cabinet 40a. All the air sucked into the cabinet 10a is pressed out of the cabinet 10a by the central fan 45.

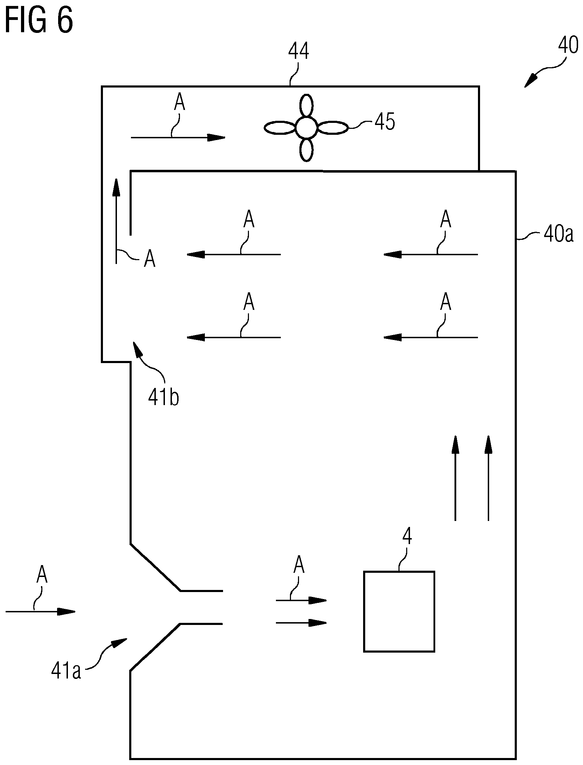

In FIG 6 a side view of the cabinet cooling system 40 of FIG 4 and FIG 5 is illustrated. FIG 6 illustrates the flowing path of the cooling air, which is sucked into the cabinet 40a through the nozzle 43 of the first air inlet 41a. As explained in context with FIG 5, the air A flows around the technical unit 4, is thereby heated up, rises up onto the upper portion of the cabinet, flows through the first air outlet 41b and through the exhaust duct system 44, where the central fan 45 is positioned.

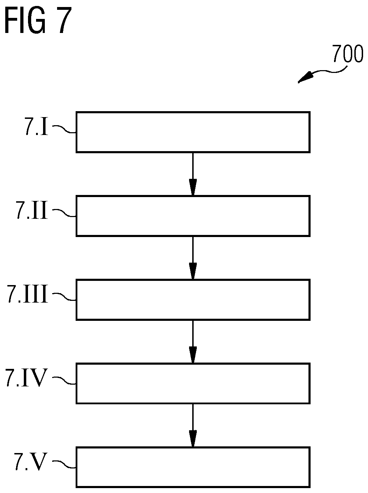

In FIG 7 a flow chart 700 is shown depicting a method for producing a cooling system 40 according to an embodiment of the invention. In step 7.1 a cabinet 40a is provided for the cooling system 40. At the next step 7.II a communicating cooling ventilation air ducting tube system is assembled to the cabinet. Further, in step 7.III one inlet 41a with a nozzle 43 for creating an overpressure for directly cooling a hot component into the cabinet is provided. In step 7.IV an exhaust duct system 44 on the top of the cabinet and in step 7.V one single central fan 45 is inserted in the air ducting tube system 44.

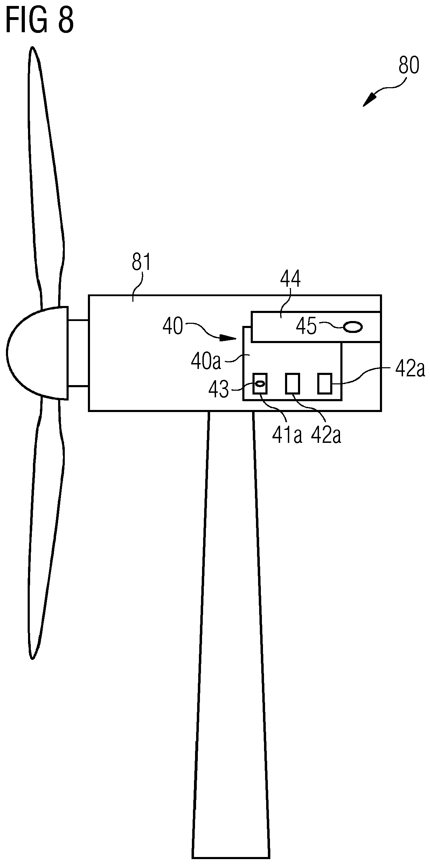

In FIG 8 a schematic cross view of a wind turbine 80 according to an embodiment of the invention is shown. The wind turbine 80 comprises a nacelle 81. The nacelle 81 includes the cabinet cooling system 40 according to an embodiment of the invention. As can be taken from FIG 4, the exhaust duct 44 is connected to the exterior of the nacelle 81 such that heat is conveyed out of the nacelle 81 and the cooling efficiency of the cabinet cooling system is improved.

Although the present invention has been disclosed in the form of preferred embodiments and variations thereon, it will be understood that numerous additional modifications and variations could be made thereto without departing from the scope of the invention. For the sake of clarity, it is to be understood that the use of 'a' or 'an' throughout this application does not exclude a plurality, and 'comprising' does not exclude other steps or elements.

## Claims

1. Cabinet cooling system (40), comprising:
- a communicating cooling ventilation air ducting tube system,
- one single central fan (45),
- at least one inlet (41a, 42a) and at least one outlet (41b, 42b),
- an exhaust duct system (44) connected to the at least one outlet (41b, 42b).

2. Cabinet cooling system, further comprising a silencer for reducing overall noise.

3. Cabinet cooling system, wherein the central fan (45) is positioned at an end portion of the exhaust duct system (44).

4. Cabinet cooling system, wherein the at least one inlet (41a) comprises a nozzle (43) for creating an overpressure for directly cooling a hot component.

5. Wind turbine (80) including a nacelle (81), which comprises the cabinet cooling system (40).

6. Method of manufacturing a cooling system (40), comprising the steps of:
- providing a cabinet (40a),
- assembling a communicating cooling ventilation air ducting tube system to the cabinet (40a),
- providing the communicating cooling ventilation air ducting tube system with at least one inlet (41a, 42a) and at least one outlet (41b, 42b),
- mounting an exhaust duct system (44) on the top of the cabinet and connecting it with at least one outlet (41b, 42b),
- inserting one single central fan (45) in the air ducting tube system (44).
